# EUROPEAN PATENT SPECIFICATION

(11) **EP 3 613 266 B1**
(45) Date of publication and mention of the grant of the patent: **19.07.2023**
(21) Application number: 17734246.6
(22) Date of filing: 31.05.2017
(51) Int. Cl.: H05K 7/14, H02M 7/00

(54) **SUSPENSION ARRANGEMENT AND HIGH VOLTAGE SYSTEM**
AUFHÄNGUNGSANORDNUNG UND HOCHSPANNUNGSSYSTEM
AGENCEMENT DE SUSPENSION ET SYSTÈME HAUTE TENSION

(43) Date of publication of application: 26.02.2020
(73) Proprietor: Hitachi Energy Switzerland AG, 5400 Baden (CH)
(72) Inventor: BERGGREN, Sören, 724 62 Västerås (SE)
(74) Representative: AWA Sweden AB
(86) International application number: PCT/EP2017/063200
(87) International publication number: WO 2018/219453

(56) References cited:
- WO-A1-2017/008717
- CN-A- 104 953 858
- CN-U- 202 257 015
- JP-A- H07 203 680
- JP-A- S61 221 571
- JP-A- 2015 183 375
- US-A- 4 318 169

## Description

### Technical Field

The present disclosure generally relates to a suspension arrangement for suspending a high voltage valve unit. In particular, a suspension arrangement for suspending a high voltage valve unit wherein the suspension arrangement comprises a coupling device allowing a support member to tilt, and a high voltage system comprising a valve unit and a suspension arrangement, are provided.

### Background

In valve halls where high voltage valve units are arranged, the valve units may be arranged as hanging valve units or as standing valve units. Hanging valve units are typically mounted suspended from the ceiling of the valve hall. Standing valve units are typically supported on the valve hall floor by means of a plurality of vertically aligned post insulators and cross bracings are often used to strengthen the support by reducing torque loads on the post insulators.

CN104270016 A discloses a valve tower of a thyristor converter valve. The valve tower body is suspended from the lower edge of a steel beam at the top of a valve hall by means of suspension insulator strings. Further prior art may be found in JP H07 203680 relating to a thyristor valve, JP S61 221571 relating to a high tension thyristor valve or WO2017/008717 relating to a bridge crane suspension device and method for valve tower.

### Summary

Load carrying support structures from which high voltage valve units are suspended may be subjected to different types of external loads. The support structures may move during transportation, installation and when subjected to environmental loads. Environmental loads may include winds, waves and seismic events. For offshore installations, sea waves in the surrounding water may excite movements of the support structure.

Excessive movements of the suspended valve units are undesired since these movements may reduce the effective electrical clearance between the valve units and the surrounding environment (e.g. the load carrying support structure) and cause damage of the valve units. For example, when the support structure moves, the movements will be transferred to the valve unit. In particular, the movements will be amplified if the exciting frequency is close to the pendulum frequency of the suspended valve unit.

One object of the present disclosure is to provide a suspension arrangement that increases the service life of a suspended high voltage valve unit.

A further object of the present disclosure is to provide a suspension arrangement that provides a reduction of forces, in particular shear forces and stresses, acting on a suspended high voltage valve unit.

A still further object of the present disclosure is to provide a suspension arrangement that contributes to a compact design of a high voltage system comprising a high voltage valve unit suspended by the suspension arrangement.

A still further object of the present disclosure is to provide a suspension arrangement having a simple, cheap and/or reliable design.

A still further object of the present disclosure is to provide a suspension arrangement enabling a simple and/or effective installation and/or maintenance.

A still further object of the present disclosure is to provide a high voltage system comprising a suspension arrangement and a high voltage valve unit solving one or more of the foregoing objects.

According to one aspect, there is provided a suspension arrangement as defined in appended independent claim 1.

Instead of fixing the at least one suspending insulator directly to the support structure, the support member constitutes an intermediate member between the at least one suspending insulator and the support structure. Since the coupling device is configured to allow relative rotation of the support member and the support structure about at least one substantially horizontal axis, horizontal or rotational movements of the support structure, for example induced by environmental loads, are not transferred to rotational movements of the valve unit. As a consequence, internal shear forces and internal stresses on the valve unit can be reduced.

The coupling device may be connected directly or indirectly (e.g. via one or more intermediate components) to the support member. Similarly, the coupling device may be connected or connectable directly or indirectly (e.g. via one or more intermediate components) to the support structure.

The high voltage valve unit according to the present disclosure may for example be constituted by a high voltage direct current (HVDC) semiconductor valve structure. Further examples of high voltage valve units are capacitor and breaker applications. A high voltage within the present disclosure may be a voltage of at least 100 kV. Thus, a high voltage system according to the present disclosure may have a system voltage of at least 100 kV.

Each suspending insulator according to the present disclosure may be constituted by a post insulator. A post insulator may alternatively be referred to as an insulated rod, insulated bar, insulated column or insulated strut. The suspending insulators have an elongated appearance and may be substantially straight. The at least one suspending insulator functions to electrically insulate the valve unit from electrical ground, i.e. from the support member, the coupling device and the support structure.

The support structure from which the suspension arrangement suspends the valve unit may be of various types, for example a platform structure or a ceiling of a valve hall. In any case, in the absence of environmental loads acting on the support structure, the support structure may be stationary.

In case the suspension arrangement is installed in a valve hall, the support structure may or may not be constituted by a valve hall ceiling. The support structure may for example alternatively be constituted by a part of a valve carrying scaffold. The support structure may have a generally planar appearance. In addition, the support structure may be horizontal or substantially horizontal. The suspension arrangement according to the present disclosure may alternatively be referred to as a hanging structure.

The coupling device may comprise a universal joint. Although universal joints are most commonly associated with cardan joints, a universal joint according to the present disclosure may be any type of joint comprising at least two degrees of angular freedom. Thus, a universal joint as used herein may alternatively be referred to as a pivoting member comprising at least two degrees of angular freedom.

As a further example in addition to a cardan joint, a universal joint may be constituted by a polyaxial ball joint. Such ball joint may be arranged to prevent relative rotation between the support member and the support structure about a vertical axis.

When the coupling device comprises a universal joint, the valve unit suspended from the support structure by the suspension arrangement will be decoupled from any angular motion of the support structure about any horizontal axis. This allows for a free pendulum motion of the valve unit. As a consequence, internal shear forces and internal stresses on the valve unit can be further reduced.

The universal joint may define two rotational axes to allow rotation of the support member relative to the support structure about the at least one substantially horizontal axis and about a further substantially horizontal axis. The universal joint may be constituted by a cardan joint. The cardan joint may comprise two hinges which may be perpendicular to each other.

The coupling device may further comprise two ears for connecting the coupling device to the support structure and two ears connected to, or integrally formed with, the support member. The two ears for connecting the coupling device to the support structure may be connectable to, connected to, or integrally formed with, the support structure. For example, the support structure may comprise two support structure beams and two of the ears of the coupling device may be connected to a respective structure beam. The coupling device may also comprise a bearing in each ear in which a pivot can be received. Such pivot may for example be formed on a cardan cross.

The coupling device may further comprise one or two yokes comprising two of the ears. For example, two ears may be connected to the support structure via a first yoke and two ears may be connected to the support member via a second yoke.

The support member may comprise, or may be constituted by, a frame. Alternatively, or in addition, the support member may be substantially horizontally oriented. According to one variant, the support member is constituted by a steel frame. Throughout the present disclosure, the support member may be referred to as an intermediate support member due to its position vertically between the support structure and the suspending insulators.

The suspension arrangement comprises at least one damping device arranged to damp relative rotations between the support member and the support structure about the at least one substantially horizontal axis, i.e. relative tilting movements. In this manner, pendulum motions of the valve unit, for example induced by sea waves acting on the support structure, can be damped. If the support structure moves at a frequency close to the Eigen frequency of the valve unit (e.g. 0.2 Hz), the movements of the support structure will be greatly amplified to the valve unit. A movement of the support structure of 10 mm may for example be amplified to a movement of the valve unit of several hundreds of millimetres. The one or more damping devices may damp the movements of the valve unit with two thirds or more.

In case the support member is substantially horizontally oriented, each damping device may be arranged to absorb relative vertical displacements between the support structure and the support member. According to one variant, the suspension arrangement comprises four damping devices.

Each of the at least one damping device is arranged between the support member and the support structure. In contrast to damping devices connected directly to the valve unit, the at least one damping device according to the present disclosure may thus be provided at electrical ground level. Connecting a damping device directly to a high voltage valve unit may also not be possible in some applications or will require an increased insulation distance. An increased insulation distance is highly undesired for offshore installations where space is expensive.

The at least one damping device may be configured to damp relative rotations having a frequency of 0.1 Hz to 0.3 Hz, such as 0.15 Hz to 0.25 Hz, such as approximately 0.2 Hz, between the support member and the support structure about the at least one substantially horizontal axis. The at least one damping device may however be tuned to optimize the structural response of the suspension arrangement. Sea waves having a wave height of 2 to 3 meters typically have a frequency of 0.2 Hz, which may be close to resonance with pendulum frequencies of the valve unit. Such sea waves may act on the support structure for several days. With optimum characteristics of the damping device, the motion of the valve unit can be reduced two to three times compared to a conventional suspension arrangement (where suspending insulators are fixedly connected to the support structure) without additional damping.

The at least one damping device may comprise, or may be constituted by, a viscous damper. The viscous damper may be a linear viscous damper. A linear viscous damper comprises one or more members moving linearly to and from one or more chambers. As an alternative, each damping device may comprise, or may be constituted by, a frictional damper. In any case, each damping device may be substantially vertically oriented.

The suspension arrangement may further comprise at least one insulator joint associated with each of the at least one suspending insulator. The suspension arrangement may comprise upper insulator joints for allowing relative rotation between the suspending insulators and the support member and/or lower insulator joints for allowing relative rotation between the suspending insulators and the valve unit. The valve unit may thus be suspended from the support member via one or more suspending insulators and via one or two insulator joints associated with each suspending insulator. The insulator joints may for example be constituted by hinges or ball joints. At ends of suspending insulators not associated with an insulator joints, the suspending insulator may be fixedly attached to the support member and/or to the valve unit.

The suspension arrangement may comprise at least three suspending insulators. According to one variant, the suspension arrangement comprises four suspending insulators. The plurality of suspending insulators may be substantially vertically oriented.

According to a further aspect, there is provided a high voltage system comprising a high voltage valve unit and a suspension arrangement according to the present disclosure for suspending the valve unit from a load carrying support structure. The high voltage system may comprise a plurality of suspension arrangements and a high voltage valve unit associated with each suspension arrangement. The system may constitute, or constitute a part of, a HVDC power transmission installation. Moreover, the system may comprise the support structure, e.g. a valve hall or the ceiling of a valve hall.

The high voltage system may be an offshore high voltage system or a land based high voltage system. For an offshore implementation, the high voltage system may be installed on a platform standing on the seabed.

As used herein, a substantially perpendicular/parallel relationship includes a perfectly perpendicular/parallel relationship as well as deviations from a perfectly perpendicular/parallel relationship with up to 5 %, such as up to 2 %. Furthermore, a substantially horizontal axis as used herein includes a perfectly horizontal axis as well as deviations from a perfectly horizontal axis with up to 5 %, such as up to 2 %. Furthermore, a vertical direction as used herein refers to a direction aligned with the direction of the force of gravity and a horizontal direction refers to a direction perpendicular to the vertical direction.

### Brief Description of the Drawings

Further details, advantages and aspects of the present disclosure will become apparent from the following embodiments taken in conjunction with the drawings, wherein:
- Fig. 1:: schematically represents a perspective view of one example of a high voltage system comprising a valve unit and a suspension arrangement; and
- Fig. 2:: schematically represents an enlarged partial perspective view of the high voltage system in Fig. 1.

### Detailed description

In the following, a suspension arrangement for suspending a high voltage valve unit wherein the suspension arrangement comprises a coupling device allowing a support member to tilt, and a high voltage system comprising a valve unit and a suspension arrangement, will be described. The same reference numerals will be used to denote the same or similar structural features.

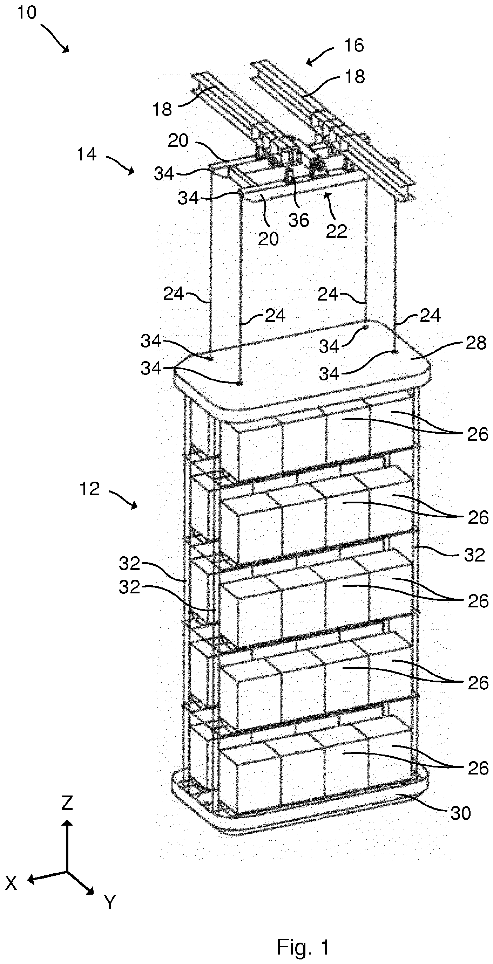

Fig. 1 schematically represents a perspective view of one example of a high voltage system 10 comprising a valve unit 12 and a suspension arrangement 14. The valve unit 12 is suspended from a load carrying support structure 16 by the suspension arrangement 14. The support structure 16 of this example is constituted by two structure beams 18 of a ceiling in a valve hall. The support structure 16, the suspension arrangement 14 and the valve unit 12 are in a neutral position in Fig. 1. Fig. 1 further denotes a vertical axis Z, a first horizontal axis X and a second horizontal axis Y, perpendicular to the first horizontal axis X.

The suspension arrangement 14 comprises a support member 20 and a coupling device 22. The coupling device 22 connects the support member 20 to the support structure 16. The suspension arrangement 14 further comprises a plurality of suspending insulators 24, four in Fig. 1, arranged to suspend the valve unit 12 from the support member 20. The suspension arrangement 14 in Fig. 1 is a hanging structure such that the entire gravity load of the valve unit 12 is transferred to the support member 20 by the suspending insulators 24.

The valve unit 12 may be a HVDC semiconductor valve unit. The valve unit 12 of this example comprises several valve layers, each comprising eight valve modules 26. An electric shield structure comprising a plurality of electric shields, such as corona shields, may be arranged around the valve layers of the valve unit 12 in order to lower the electrical fields to minimize the risk for partial discharge and/or flashover.

The valve unit 12 of this example further comprises a top plate 28, a bottom plate 30 and four pairs of internal hanger elements 32. The suspension arrangement 14 in Fig. 1 also comprises two insulator joints 34 associated with each suspending insulator 24. In this example, each suspending insulator 24 is attached to the top plate 28 of the valve unit 12 via an insulator joint 34 and each suspending insulator 24 is attached to the support member 20 via an insulator joint 34. Each insulator joint 34 may comprise at least one hinge.

A typical height of the valve unit 12 is 7000 mm. A typical length of the suspending insulator 24 is 3000 mm. The suspending insulators 24 are made of an electrically insulating material, for example porcelain, polymer or epoxy. The suspending insulators 24 establish an insulating distance for the valve unit 12 to ground, i.e. to the support member 20. Each suspending insulator 24 may have a core diameter of approximately 30 mm.

The high voltage valve unit 12 of this example has a substantially rectangular cross section and one suspending insulator 24 is associated with each corner of the valve unit 12. However, the valve unit 12 may have alternative shapes. The valve unit 12 may be subjected to hundreds of kilovolts.

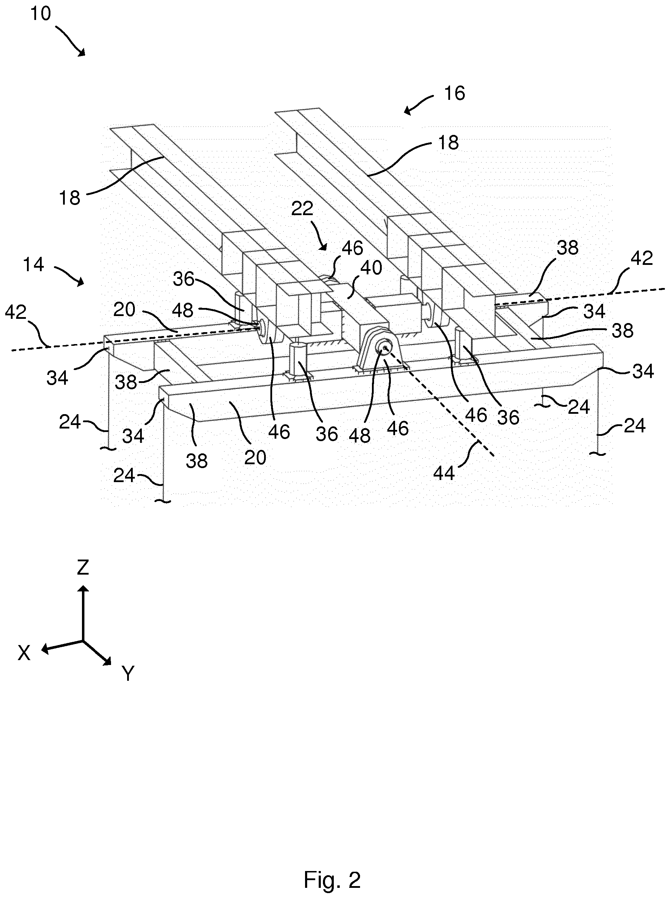

The suspension arrangement 14 in Fig. 1 also comprises a plurality of damping devices 36 (only one is denoted in Fig. 1) which are described in more detail in connection with Fig. 2.

Fig. 2 schematically represents an enlarged partial perspective view of the high voltage system 10 in Fig. 1. Also in Fig. 2, the high voltage system 10 is in a neutral position.

As can be seen in Fig. 2, the support member 20 of this example is constituted by a frame composed of four support beams 38. The support beams 38 may for example be made of steel. The support member 20 has a generally flat appearance and is oriented substantially horizontally in the neutral position. In comparison with the support structure 16, the support member 20 will also remain substantially horizontally oriented when the support structure 16 tilts. The support member 20, together with the valve unit 12, may for example tilt only ± 10 when the support structure 16 tilts or when the support structure 16 moves horizontally.

Fig. 2 further shows that the coupling device 22 comprises a universal joint 40, here implemented as a cardan joint comprising a cardan cross. The cardan joint defines two rotational axes 42, 44. The coupling device 22 further comprises four ears 46 housing bearings, e.g. roller bearing or needle bearings. Two ears 46 are attached to a respective structure beam 18 of the support structure 16 and two ears 46 are attached to a respective support beam 38 of the support member 20.

Two pivots 48 of the universal joint 40 are received in a respective bearing of an ear 46 connected to a structure beam 18 of the support structure 16 and two pivots 48 of the universal joint 40 are received in a respective bearing of an ear 46 connected to a support beam 38 of the support member 20. Thereby, the universal joint 40 is arranged to rotate with respect to the support structure 16 about the rotational axis 42 parallel with the X-axis and the support member 20 is arranged to rotate with respect to the universal joint 40 about the rotational axis 44 parallel with the Y-axis. As a consequence, the support member 20 can tilt about any horizontal axis relative to the support structure 16. The coupling device 22 of this example therefore allows rotation of the support member 20 relative to the support structure 16 about at least one substantially horizontal axis.

The damping devices 36 are constituted by viscous dampers and are arranged substantially vertically. As can be seen in Fig. 2, each damping device 36 is arranged between the support member 20 and the support structure 16, more specifically between a support beam 38 of the support member 20 and a structure beam 18 of the support structure 16.

The damping devices 36 may be commercially available damping devices. Each damping device 36 may have a fixed damping constant, e.g. set by the manufacturer, or an adjustable damping constant for on site adjustments. The damping constant may be a few hundred kNs/m. The working region of the damping devices 36 in the vertical direction Z may be of the order ± 5 mm from the illustrated neutral position. The damping devices 36 may be configured to damp relative tilting movements between the support member 20 and the support structure 16 having a frequency close to the Eigen frequency of the suspended valve unit 12 of approximately 0.2 Hz, e.g. horizontal movements of the support structure 16 induced by sea waves having a height of 2 to 3 meters.

The damping devices 36 each provides a damping force against relative movements between the support member 20 and the support structure 16. For example, if the support structure 16 is tilted clockwise about the rotational axis 44, the two left damping devices 36 are expanded and the two right damping devices 36 (only one is denoted in Fig. 2) are compressed. As a further example, if the support structure 16 moves to the right and then stops, the two left damping devices 36 are expanded, the two right damping devices 36 are compressed and the support member 20 rotates only slightly about the rotational axis 44. The damping devices 36 are thereby arranged to damp relative rotations between the support member 20 and the support structure 16 about at least one substantially horizontal axis (rotational axis 44 in this example).

While the present disclosure has been described with reference to exemplary embodiments, it will be appreciated that the present invention is not limited to what has been described above. For example, it will be appreciated that the dimensions of the parts may be varied as needed. Accordingly, it is intended that the present invention is limited only by the scope of the claims appended hereto.

## Claims

1. Suspension arrangement (14) for suspending a high voltage valve unit (12) from a load carrying support structure (16), the suspension arrangement (14) comprising:
- a support member (20);
- at least one suspending insulator (24) for suspending the valve unit (12) from the support member (20); and
- a coupling device (22) configured to connect the support member (20) to the support structure (16) and configured to allow rotation of the support member (20) relative to the support structure (16) about at least one substantially horizontal axis;
said suspension arrangement being **characterized in that** it further comprises:
- at least one damping device (36) arranged to damp relative rotations between the support member (20) and the support structure (16) about the at least one substantially horizontal axis;
wherein each of the at least one damping device (36) is arranged between the support member (20) and the support structure (16).

2. The suspension arrangement (14) according to claim 1, wherein the coupling device (22) comprises a universal joint (40).

3. The suspension arrangement (14) according to claim 2, wherein the universal joint (40) defines two rotational axes (42, 44) to allow rotation of the support member (20) relative to the support structure (16) about the at least one substantially horizontal axis and about a further substantially horizontal axis.

4. The suspension arrangement (14) according to claim 2 or 3, wherein the universal joint (40) is constituted by a cardan joint.

5. The suspension arrangement (14) according to claim 4, wherein the coupling device (22) further comprises two ears (46) for connecting the coupling device (22) to the support structure (16) and two ears (46) connected to, or integrally formed with, the support member (20).

6. The suspension arrangement (14) according to any of the preceding claims, wherein the support member (20) comprises, or is constituted by, a frame.

7. The suspension arrangement (14) according to any of the preceding claims, wherein the support member (20) is substantially horizontally oriented.

8. The suspension arrangement (14) according to any of the preceding claims, wherein the at least one damping device (36) is configured to damp relative rotations having a frequency of 0.1 Hz to 0.3 Hz, such as 0.15 Hz to 0.25 Hz, such as approximately 0.2 Hz, between the support member (20) and the support structure (16) about the at least one substantially horizontal axis.

9. The suspension arrangement (14) according to any of the preceding claims, wherein the at least one damping device (36) comprises, or is constituted by, a viscous damper.

10. The suspension arrangement (14) according to any of the preceding claims, further comprising at least one insulator joint (34) associated with each of the at least one suspending insulator (24).

11. The suspension arrangement (14) according to any of the preceding claims, wherein the suspension arrangement (14) comprises at least three suspending insulators (24).

12. High voltage system (10) comprising a high voltage valve unit (12) and a suspension arrangement (14) according to any of the preceding claims for suspending the valve unit (12) from a load carrying support structure (16).

13. The high voltage system (10) according to claim 12, wherein the high voltage system (10) is an offshore high voltage system (10) or a land based high voltage system (10).

## Patentansprüche

1. Aufhängungsanordnung (14) zum Aufhängen einer Hochspannungsventileinheit (12) an einer lasttragenden Tragstruktur (16), wobei die Aufhängungsanordnung (14) Folgendes umfasst:
- ein Tragelement (20),
- wenigstens einen hängenden Isolator (24) zum Aufhängen der Ventileinheit (12) an dem Tragelement (20) und
- eine Kopplungsvorrichtung (22), die dazu ausgelegt ist, das Tragelement (20) mit der Tragstruktur (16) zu verbinden, und dazu ausgelegt ist, eine Drehung des Tragelements (20) relativ zu der Tragstruktur (16) um wenigstens eine im Wesentlichen horizontale Achse zu ermöglichen,
wobei die Aufhängungsanordnung **dadurch gekennzeichnet ist, dass** sie ferner Folgendes umfasst:
- wenigstens eine Dämpfungsvorrichtung (36), die so angeordnet ist, dass sie relative Drehungen zwischen dem Tragelement (20) und der Tragstruktur (16) um die wenigstens eine im Wesentlichen horizontale Achse dämpft,
wobei die wenigstens eine Dämpfungsvorrichtung (36) jeweils zwischen dem Tragelement (20) und der Tragstruktur (16) angeordnet ist.

2. Aufhängungsanordnung (14) nach Anspruch 1, wobei die Kopplungsvorrichtung (22) ein Kreuzgelenk (40) umfasst.

3. Aufhängungsanordnung (14) nach Anspruch 2, wobei das Kreuzgelenk (40) zwei Drehachsen (42, 44) definiert, um eine Drehung des Tragelements (20) relativ zu der Tragstruktur (16) um die wenigstens eine im Wesentlichen horizontale Achse und um eine weitere im Wesentlichen horizontale Achse zu ermöglichen.

4. Aufhängungsanordnung (14) nach Anspruch 2 oder 3, wobei das Kreuzgelenk (40) durch ein Kardangelenk gebildet ist.

5. Aufhängungsanordnung (14) nach Anspruch 4, wobei die Kopplungsvorrichtung (22) ferner zwei Laschen (46) zum Verbinden der Kopplungsvorrichtung (22) mit der Tragstruktur (16) und zwei Laschen (46) umfasst, die mit dem Tragelement (20) verbunden oder mit demselben einstückig ausgebildet sind.

6. Aufhängungsanordnung (14) nach einem der vorhergehenden Ansprüche, wobei das Tragelement (20) einen Rahmen umfasst oder durch einen solchen gebildet ist.

7. Aufhängungsanordnung (14) nach einem der vorhergehenden Ansprüche, wobei das Tragelement (20) im Wesentlichen horizontal ausgerichtet ist.

8. Aufhängungsanordnung (14) nach einem der vorhergehenden Ansprüche, wobei die wenigstens eine Dämpfungsvorrichtung (36) dazu ausgelegt ist, relative Drehungen mit einer Frequenz von 0,1 Hz bis 0,3 Hz, wie zum Beispiel 0,15 Hz bis 0,25 Hz, wie zum Beispiel ungefähr 0,2 Hz, zwischen dem Tragelement (20) und der Tragstruktur (16) um die wenigstens eine im Wesentlichen horizontale Achse zu dämpfen.

9. Aufhängungsanordnung (14) nach einem der vorhergehenden Ansprüche, wobei die wenigstens eine Dämpfungsvorrichtung (36) einen viskosen Dämpfer umfasst oder durch einen solchen gebildet ist.

10. Aufhängungsanordnung (14) nach einem der vorhergehenden Ansprüche, ferner umfassend wenigstens ein Isolatorgelenk (34), das jeweils dem wenigstens einen hängenden Isolator (24) zugeordnet ist.

11. Aufhängungsanordnung (14) nach einem der vorhergehenden Ansprüche, wobei die Aufhängungsanordnung (14) wenigstens drei hängende Isolatoren (24) umfasst.

12. Hochspannungssystem (10), umfassend eine Hochspannungsventileinheit (12) und eine Aufhängungsanordnung (14) nach einem der vorhergehenden Ansprüche zum Aufhängen der Ventileinheit (12) an einer lasttragenden Tragstruktur (16).

13. Hochspannungssystem (10) nach Anspruch 12, wobei das Hochspannungssystem (10) ein der Küste vorgelagertes Hochspannungssystem (10) oder ein auf dem Festland befindliches Hochspannungssystem (10) ist.

## Revendications

1. Agencement de suspension (14) permettant de suspendre une unité de valve haute tension (12) à une structure de support portant une charge (16), l'agencement de suspension (14) comprenant :
un élément de support (20) ;
au moins un isolant de suspension (24) permettant de suspendre l'unité de valve (12) à l'élément de support (20) ; et
un dispositif d'accouplement (22) conçu pour relier l'élément de support (20) à la structure de support (16) et conçu pour permettre la rotation de l'élément de support (20) par rapport à la structure de support (16) autour d'au moins un axe sensiblement horizontal ;
ledit agencement de suspension étant **caractérisé en ce qu'**il comprend en outre :
au moins un dispositif d'amortissement (36) conçu pour amortir les rotations relatives entre l'élément de support (20) et la structure de support (16) autour de l'au moins un axe sensiblement horizontal ;
chacun de l'au moins un dispositif d'amortissement (36) étant disposé entre l'élément de support (20) et la structure de support (16).

2. Agencement de suspension (14) selon la revendication 1, le dispositif d'accouplement (22) comprenant un joint universel (40).

3. Agencement de suspension (14) selon la revendication 2, le joint universel (40) définissant deux axes de rotation (42, 44) pour permettre la rotation de l'élément de support (20) par rapport à la structure de support (16) autour de l'au moins un axe sensiblement horizontal et autour d'un autre axe sensiblement horizontal.

4. Agencement de suspension (14) selon la revendication 2 ou 3, le joint universel (40) étant constitué d'un joint de cardan.

5. Agencement de suspension (14) selon la revendication 4, le dispositif d'accouplement (22) comprenant en outre deux pattes (46) pour relier le dispositif d'accouplement (22) à la structure de support (16) et deux pattes (46) reliées à l'élément de support (20) ou formées d'un seul tenant avec celui-ci.

6. Agencement de suspension (14) selon l'une quelconque des revendications précédentes, l'élément de support (20) comprenant, ou étant constitué par, un cadre.

7. Agencement de suspension (14) selon l'une quelconque des revendications précédentes, l'élément de support (20) étant orienté sensiblement horizontalement.

8. Agencement de suspension (14) selon l'une quelconque des revendications précédentes, l'au moins un dispositif d'amortissement (36) étant conçu pour amortir les rotations relatives ayant une fréquence de 0,1 Hz à 0,3 Hz, telle que de 0,15 Hz à 0,25 Hz, telle qu'environ 0,2 Hz, entre l'élément de support (20) et la structure de support (16) autour de l'au moins un axe sensiblement horizontal.

9. Agencement de suspension (14) selon l'une quelconque des revendications précédentes, l'au moins un dispositif d'amortissement (36) comprenant, ou étant constitué par, un amortisseur hydraulique.

10. Agencement de suspension (14) selon l'une quelconque des revendications précédentes, comprenant en outre au moins un joint d'isolant (34) associé à chacun de l'au moins un isolant de suspension (24).

11. Agencement de suspension (14) selon l'une quelconque des revendications précédentes, l'agencement de suspension (14) comprenant au moins trois isolants de suspension (24).

12. Système haute tension (10) comprenant une unité de valve haute tension (12) et un agencement de suspension (14) selon l'une quelconque des revendications précédentes pour suspendre l'unité de valve (12) à une structure de support portant une charge (16).

13. Système haute tension (10) selon la revendication 12, le système haute tension (10) étant un système haute tension offshore (10) ou un système haute tension terrestre (10).
